## Europäisches Patentamt
## European Patent Office
## Office européen des brevets

(11) Veröffentlichungsnummer: **0 224 501**
**B1**

# EUROPÄISCHE PATENTSCHRIFT

(45) Veröffentlichungstag der Patentschrift:
23.08.89

(51) Int. Cl.⁴: **H 05 K 13/02,** B 65 G 65/00

(21) Anmeldenummer: 86902801.9

(22) Anmeldetag: 14.05.86

(86) Internationale Anmeldenummer:
PCT/DE 86/00202

(87) Internationale Veröffentlichungsnummer:
WO 86/07520 (18.12.86 Gazette 86/27)

(54) **STAPELVORRICHTUNG FÜR EINHEITLICHE, INSBESONDERE PLATTENFÖRMIGE TEILE.**

(30) Priorität: 12.06.85 DE 3521010

(43) Veröffentlichungstag der Anmeldung:
10.06.87 Patentblatt 87/24

(45) Bekanntmachung des Hinweises auf die Patenterteilung:
23.08.89 Patentblatt 89/34

(84) Benannte Vertragsstaaten:
DE FR GB

(56) Entgegenhaltungen:
DE-A-3 232 611
US-A-3 995 748

(73) Patentinhaber: ROBERT BOSCH GMBH, Postfach 50, D-7000 Stuttgart 1 (DE)

(72) Erfinder: GÖSSL, Erhard, Steinbeisstr. 46, D-7016 Gerlingen (DE)
Erfinder: LUTZ, Hans, Missenharterweg 24, D-7016 Gerlingen (DE)
Erfinder: SCHÖTTLE, Peter, Knappenweg 6B, D-7000 Stuttgart 80 (DE)

EP 0 224 501 B1

LIBER, STOCKHOLM 1989

## Beschreibung

### Stand der Technik

Die Erfindung geht aus von einer Stapelvorrichtung nach der Gattung des Hauptanspruchs. Es ist bekannt, einheitliche, insbesondere plattenförmige Teile von einem Vorrat einzeln auf ein Förderband aufzulegen und nach Durchlaufen einer oder mehrerer Bearbeitungsstationen in einem Behälter zu stapeln. So werden beispielsweise Schaltungen mit kleinen Abmessungen in der Serienfertigung dadurch hergestellt, daß auf einer relativ großflächigen, dünnen Metallplatte eine Vielzahl kleiner Flächen bestimmter Konfiguration zunächst mit einem Isolierstoff, beispielsweise mit Glas oder Keramik beschichtet werden. Sodann wird auf diese Platte eine Leiterschicht, beispielsweise aus Tantal, aufgebracht. Dies geschieht in der Regel durch Aufdampfen bzw. Aufstäuben des Beschichtungsmaterials in einem evakuierbaren Rezipienten. Das Verfahren beruht darauf, daß man die Platten in eine Vakuumkammer (Rezipient) einbringt, die ein aus dem Beschichtungsmaterial bestehendes Target enthält, daß sodann bei reduziertem Druck ein Zerstäubungsgas, beispielsweise Argon, in die Kammer eingeleitet und eine elektrische Spannung an das Target zur Erzeugung eines Plasmas zwischen Target und Platte angelegt wird, wodurch sich ein Überzug des Targetmaterials auf der Platte niederschlägt. Der Durchlauf der Platten durch die Beschichtungsstation geschieht kontinuierlich mit der vom Förderband vorgegebenen Geschwindigkeit. Anschließend werden die einseitig und ganzflächig beschichteten Platten in einem innerhalb der Kammer angeordneten Behälter gestapelt, in welchem sie verbleiben, bis sie genügend abgekühlt sind. Die von der Fördereinrichtung herangeführten Platten werden im Behälter so abgelegt, daß die Schichtseite und die Rückseite zweier benachbarter Platten aufeinanderliegen.

Die aus dem Behälter entnommenen Platten werden außerhalb der Kammer geätzt, um die Leiterstruktur herzustellen. Daraufhin werden die Flächengebilde aus der Platte herausgestanzt und mit Anschlußdrähten versehen.

Platten, die in der vorstehend beschriebenen Weise in der Vakuumkammer gestapelt wurden zeigten bei nachfolgenden Ätzvorgängen im Bereich der Isolierschicht unterschiedliches Ätzverhalten. Die Leiterschicht war an einigen Stellen der beschichteten Flächen nur sehr schwer abätzbar und führte an anderen Stellen daher zu Unterätzungen. Die Ursache hierfür liegt darin, daß durch Relativbewegungen der gestapelten Platten zueinander ein Abrieb der nicht beschichteten Rückseite der Platten auftritt, und daß ferner das Gewicht des Stapels an den erhabenen Stellen der Isolierschicht Druckstellen erzeugt, innerhalb derer das Beschichtungsmaterial verdichtet wird.

## Vorteile der Erfindung

Die erfindungsgemäße Stapelvorrichtung mit den kennzeichnenden Merkmalen des Hauptanspruchs hat demgegenüber den Vorteil, daß die vorstehend geschilderten Erscheinungen, insbesondere ein Abrieb und Abdruck der Rückseiten der Platten an der Schichtseite der jeweils darüber liegenden Platte, nicht mehr auftreten können. Dadurch konnte das Ätzverhalten der extrem dünnen Leiterschichten entscheidend verbessert und die Ausschußquote reduziert werden. Die Aufnahmekapazität des Teilebehälters wird durch die Verwendung von Zwischenlagen nicht wesentlich verringert, da diese aus sehr dünnem, glattflächigen Material bestehen können. Außer zum Schutz von Leiterplatten der beschriebenen Art können die Zwischenlagen auch zum Schutz anderer, stapelbarer Teile mit einheitlicher Form dienen, deren Oberfläche eine empfindliche Material und/oder Strukturbeschaffenheit aufweist. In der DE-OS-2 229 254 ist auf stapelbare Teile hingewiesen, die in Rahmen untergebracht werden können, wenn ihre Form oder ihre Zerbrechlichkeit eine unmittelbar Stapelung nicht ermöglicht. Es handelt sich hier um Teile, die bereits vor der Stapelung in Rahmen eingesetzt werden, die ein Stapeln dieser Teile erst ermöglichen.

Durch die in den Unteransprüchen aufgeführten Maßnahmen sind vorteilhafte Weiterbildungen und Verbesserungen der im Hauptanspruch angegebenen Stapelvorrichtung möglich. Besonders vorteilhaft ist es, daß die Zwischenlagen als in sich formsteife Rahmen ausgebildet sind, welche an Randbereichen der Front- und Rückseite der abgelegten Teile anliegen. Die Breite dieser Rahmen kann hierbei so bemessen werden, daß sie nur außerhalb eines zu schützenden Nutzbereichs an der Platte zur Anlage kommen. Dadurch entsteht zwischen zwei benachbarten Platten jeweils ein Zwischenraum, der im Falle zuvor erhitzter Platten für eine gleichmäßige Abkühlung derselben sorgt. Eine für automatisch arbeitende Stapelvorrichtungen besonders geeignete Bauart besteht darin, daß die Zwischenlagen in einem Magazin gestapelt sind, und daß in dem Magazin eine Vorrichtung zum Transport bzw. zur Freigabe jeweils einer Zwischenlage zwischen zwei aufeinanderfolgenden Teileablagen vorgesehen ist. Dabei läßt sich eine raumsparende Bauweise dadurch erzielen, daß das Magazin und die Vorrichtung zum Transport bzw. zur Freigabe der Zwischenlagen innerhalb des zur Ablage der Teile dienenden Behälters angeordnet sind. Ein besonderes Magazin für die Zwischenlagen wird entbehrlich, wenn gemäß einem weiteren Merkmal der Erfindung der die abgelegten Teile aufnehmende Behälter als Magazin für die Zwischenlagen ausgebildet ist. Eine besonders zweckmäßige Bauart, die mit Schwerkraft arbeitet und nur eine Freigabevorrichtung für die Zwischenlagen benötigt, besteht darin, daß der Behälter zur Fördereinrichtung hin offen und während des Stapelvorgangs entgegen der Stapelrichtung beweglich ist, und daß die Zwischenlagen unter Belassung eines Freiraums zum Ablegen jeweils eines Teils im Behälter gelagert sind.

## Zeichnung

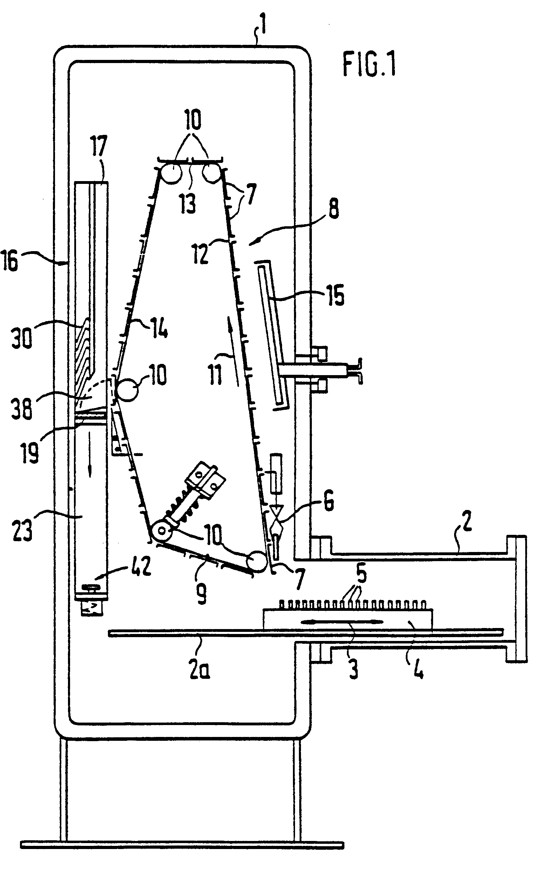

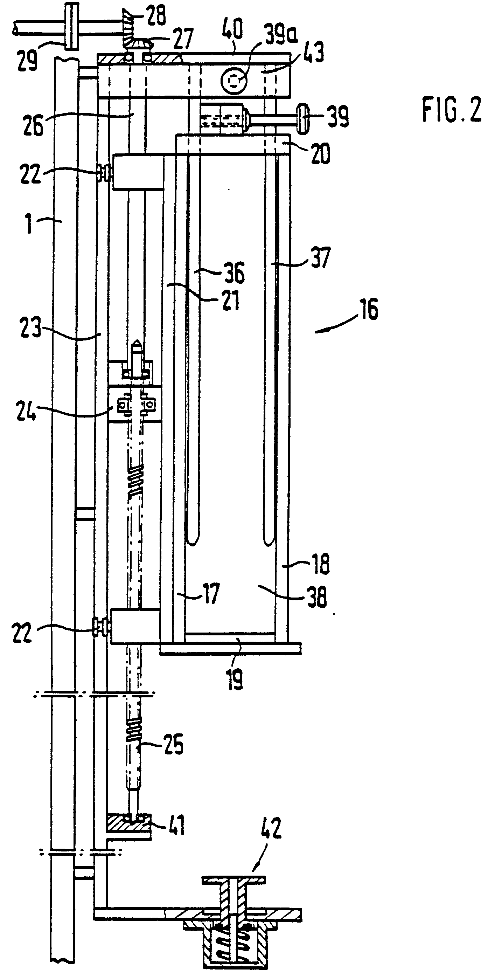

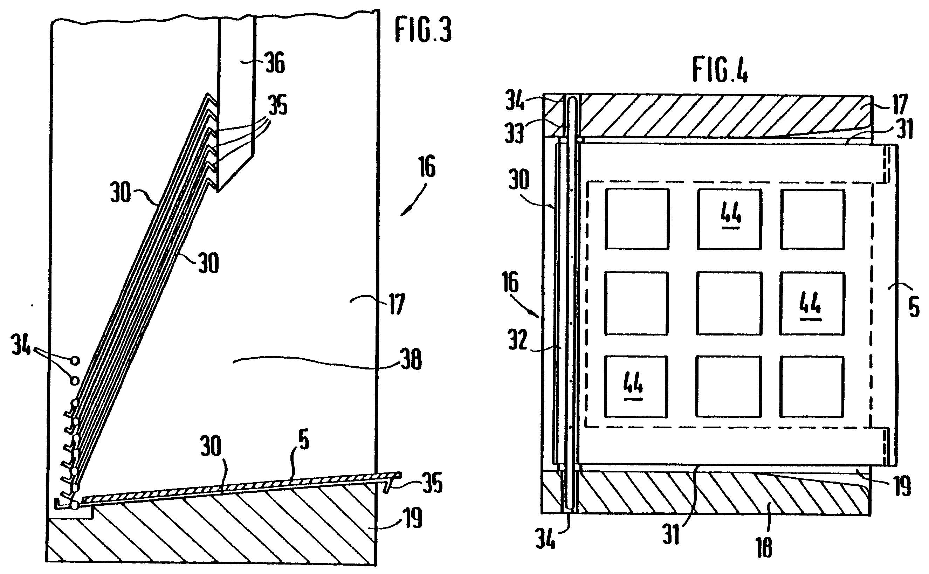

Ein Ausführungsbeispiel der Erfindung ist in der Zeichnung dargestellt und in der nachfolgenden Beschreibung unter Angabe weiterer Vorteile näher erläutert. Es zeigen Figur 1 eine in eine Beschichtungsanlage integrierte Stapelvorrichtung in schematischer Darstellung, Figur 2 eine vergrößerte Ansicht mit Einzelheiten der Stapelvorrichtung gemäß Figur 1, Figur 3 einen Teil des in Figur 1 dargestellten Stapelbehälters im Längsschnitt, Figur 4 die Anordnung nach Figur 3 in einem Querschnitt.

## Beschreibung des Ausführungsbeispiels

In Figur 1 ist mit 1 ein vakuumdicht verschließbares Gehäuse bezeichnet, an dem eine Schleuse 2 zum Einführen eines auf Schienen 2a in Richtung des Doppelpfeils 3 bewegbaren Stabmagazins 4 befestigt ist. Das Magazin 4 ist mit Metallplatten 5 gefüllt, deren eine Fläche mit einem Leitersubstrat, beispielsweise Tantal, beschichtet werden soll. Oberhalb des Magazins 4 ist im Gehäuse 1 ein in vertikaler Richtung auf- und abbewegbarer Klemmgreifer 6 angeordnet, welcher die Platten 5 einzeln aus dem Magazin 4 entnimmt und soweit anhebt, daß sie vom Rand der hochlaufenden, mit Winkeln versehenen Substrataufnahmen 7 einer Fördereinrichtung 8 erfaßt werden. Die Fördereinrichtung hat ein endloses Förderband 9, das über Umlenkrollen 10 läuft, von denen mindestens eine gefedert ist. Das Förderband 9 wird in Richtung des Pfeils 11 angetrieben. Die in sich starren Substrataufnahmen sind auf dem Förderband so befestigt, daß sie dessen Umlenkung folgen, ohne ihre Form zu verändern. Das Förderband 9 hat einen schräg nach oben verlaufenden Abschnitt 12, der in einen horizontalen Abschnitt 13 übergeht. An diesen Abschnitt schließt sich ein schräg nach unten gerichteter Abschnitt 14 an. Am Ende des durch eine Umlenkrolle 10 markierten Abschnitts 14 befindet sich die Stelle, an welcher die Teile 5 durch Kippen der Substrataufnahmen 7 vom Förderband 9 abgeworfen werden. Das Förderband hat zweckmäßigerweise zwei parallele Gliederketten, die mit Verzahnungen der Umlenkrollen in Eingriff stehen und zwischen denen die Substrataufnahmen 7 befestigt sind.

Im Bereich des Abschnitts 12 des Förderbands 9 liegt die Substratbeschichtungszone, von welcher in Figur 1 eine wassergekühlte, an einen Hochfrequenzgenerator angeschlossene Kathode 15 mit dem aufzustäubenden Material dargestellt ist.

Die beschichteten und durch Kippen der Substrataufnahmen 7 vom Förderband 9 abgeworfenen Platten 5 fallen mit der Schichtseite nach unten in einen zum Förderband 7 hin offenen, schachtartig ausgebildeten Stapelbehälter 16, der zwei parallele Seitenwände 17, 18, einen Boden 19 und eine Verbindungsleiste 20 hat. Der Behälter 16 sitzt auf einem Tragewinkel 21, der mittels mehrerer Rollen 22 an einer am Gehäuse 1 befestigten Schiene 23 in vertikaler Richtung beweglich geführt ist. Am Tragewinkel 21 ist eine Mutter 24 befestigt, die von einer Gewindespindel 25 durchgriffen wird. Die Spindel 25 ist mit ihrem einen Ende an der Führungsschiene 23 gelagert, während ihr anderes Ende drehfest mit einer Welle 26 verbunden ist, die über einen aus zwei Kegelrädern 27, 28 bestehenden Winkeltrieb und eine lösbare Kupplung 29 von einem nicht dargestellten Motor antreibbar ist. Die Mutter 24 ist geteilt, d.h. sie besteht aus zwei Gewindehalbschalen, die in geöffnetem Zustand ein Verschieben des Tragewinkels 21 bezüglich der Gewindespindel 25 gestatten.

Um die empfindliche Schichtseite der im Behälter 16 gestapelten Platten 5 zu schützen, sind Zwischenlagen 30 vorgesehen, die beim Stapelvorgang zwischen jeweils zwei aufeinanderfolgenden Platten 5 eingebracht werden. Diese Zwischenlagen sind, wie aus Figur 4 ersichtlich, als Rahmen ausgebildet, die nur an Randbereichen der Schicht- und Rückseiten der gestapelten Platten 5 anliegen. Jeder der zum Förderband 9 hin offenen Rahmen besteht aus zwei parallelen Schenkeln 31 und einem diese verbindenden Quersteg 32. Nahe der rückwärtigen Begrenzungskante ist am Steg eine Achse 33 befestigt, welche in Bohrungen 34 eingreift, die in den parallelen Seitenwänden 17, 18 des Behälters 16 ausgebildet sind. Die Bohrungen liegen vertikal übereinander.

Die parallelen Schenkel 31 des Rahmens sind an ihrem freien Ende abgewinkelt. Mit diesen Abwinkelungen 35 stützen sie sich an zwei Leisten 36, 37 ab, die parallel zueinander verlaufen und sich innerhalb des Behälters in Bewegungsrichtung desselben erstrecken. Die Leisten 36, 37 bilden eine Vorrichtung zur Freigabe jeweils eines Rahmens während des Betriebs der Anlage. Zwischen den freien Enden der Leisten 37, 38 und dem Boden des Behälters 16 befindet sich ein Freiraum 38 zum Einkippen der beschichteten Platten 5 vom Förderband 9 in den Behälter 16.

Der Behälter 16 und die Leisten 36, 37 sind mittels einer Gewindeschraube 39 lösbar miteinander verbunden. Eine weitere Gewindeschraube 39a dient zum lösbaren Befestigen der Leisten 36, 37 an einer Platte 40 der Magazineinrichtung.

Die Gewindespindel 25 ist oberhalb ihrer unteren Lagerung 41 freigedreht, damit die Mutter 24 nicht festläuft, wenn der Behälter 16 gefüllt, der Antrieb jedoch noch nicht ausgekuppelt ist. Um die Belastung der letzten Gewindegänge der Spindel 25 durch den gefüllten Behälter 16 zu reduzieren, ist ferner ein in vertikaler Richtung gefederter Teller 42 vorgesehen, auf den der Tragewinkel 21 am Ende des Stapelvorgangs bei ganz abgesenktem Behälter auftrifft.

Die Arbeitsweise der beschriebenen Vorrichtung ist wie folgt:

Der aus dem Gehäuse 1 herausgenommene Behälter 16 wird nach Entleerung so gekippt, daß sich die Zwischenlagen 30 etwa parallel zu den Längskanten der Seitenwände 17, 18 des Behälters ausrichten. Danach werden die beiden, durch einen Steg 43 an einem Ende miteinander verbundenen Leisten 36, 37 durch zwei in der Verbindungsleiste 20 ausgebildete Ausnehmungen in den Behälter 16 eingeführt und mittels der Gewindeschraube 39 an diesem befestigt. Durch Aufrichten und Kippen des Behälters 16 werden die Zwischenlagen 30 in die in Figur 3 dargestellte Lage gebracht, in welcher sie sich mit ihren Abwinkelungen 35 unter Schrägstellung an den Leisten 36, 37 abstützen. Nun kann der Behälter 16 im Gehäuse 1 auf den Tragewinkel 21 aufgesetzt werden. Anschließend wird der Tragewinkel 21 bei geöffneter Mutter 24 mit dem Behälter 16 nach oben gefahren, bis die Gewindeschraube 39a zum Befestigen der Leisten 36, 37 auf der Platte 40 der Magazinvorrichtung angebracht werden kann. Die Mutter 24 wird geschlossen und die Gewindeschraube 39 entfernt. Damit sitzt der Behälter 16 auf dem durch die Gewindespindel 25 gehaltenen Tragewinkel 21 auf, während die Leisten 36, 37 von der Platte 40 der Magazinvorrichtung gehalten werden.

Durch Drehen der Gewindespindel 25 bei gelöster Kupplung 29 wird der Tragewinkel 21 mit dem Behälter 16 soweit abgesenkt, bis die Leisten 36, 37 die unterste Zwischenlage 30 freigeben und diese unter dem Einfluß der Schwerkraft auf den Boden 19 des Behälters 16 fällt. Nach dieser Einstellung wird ein Vorratsmagazin 4 mit unbeschichteten Platten 5 eingeschoben, das Gehäuse 1 verschlossen und evakuiert. Nach Einstellung der Beschichtungsbedingungen wird das Förderband 9 eingeschaltet. Zum gegebenen Zeitpunkt wird der Vorschub für das Magazin 4 und der Antrieb für die Gewindespindel 24 über die jeweilige Kupplung mit dem Antrieb der Fördereinrichtung 9 verbunden, die Gewindespindel jedoch erst eingekuppelt, wenn die erste beschichtete Platte 5 vom Förderband 9 in den Behälter eingeworfen wurde. Die Gewindespindel 25 läuft synchron mit dem Förderband 9, derart, daß jeweils nach Ablage einer beschichteten Platte 5 im Behälter 16 von den Leisten 36, 37 eine Zwischenlage 30 freigegeben wird, welche auf die Rückseite der zuletzt gestapelten Platte fällt und diese von der Schichtseite der anschließend abgelegten Platte trennt. Dieser Vorgang wiederholt sich während der kontinuierlichen Absenkung des Behälters 16 solange, bis der rollengeführte Tragewinkel 21 auf den gefederten Teller 42 auftrifft, der unter dem Gewicht des gefüllten Behälters soweit nachgibt, bis sich die Mutter 24 in dem freigedrehten Abschnitt der Gewindespindel 25 befindet. Nun können die Antriebe abgeschaltet und nach einer Abkühlungsphase der gefüllte Behälter 16 aus dem Gehäuse 1 entnommen werden.

Wie aus Figur 4 ersichtlich ist, hat die Platte 5 mehrere flächige Zonen 44, die vor dem Beschichten mit Leitermaterial mit einer Isolierschicht versehen wurden. Nach der Entnahme der Platten aus dem Behälter 16 wird die Schaltungsstruktur aufgebracht, geätzt und zuletzt die Zonen aus der Platte herausgestanzt und einzeln weiterverarbeitet. Wesentlich ist dabei, daß die empfindlichen Zonen 44 während des Stapelvorgangs durch die Zwischenlage 30 von der Rückseite der jeweils darunterliegenden Platte unter Bildung eines Zwischenraums getrennt sind, wobei die Zwischenlagen selbst infolge ihrer rahmenartigen Ausbildung außerhalb des Nutzbereichs an den Platten 5 anliegen.

Im Ausführungsbeispiel ist der die beschichteten Platten 5 aufnehmende Behälter 16 zugleich als Magazin für die Zwischenlagen 30 ausgebildet. Abweichend hiervon könnte zum Unterbringen der Zwischenlagen auch ein vom Behälter 16 getrenntes Magazin vorgesehen sein, das im Behälter 16 oder außerhalb desselben angeordnet ist. Anstelle separater Zwischenlagen könnten auch Zwischenlagen verwendet werden, die einenends aneinandergekettet sind und sich zickzackförmig unter Einschluß jeweils einer Platte aufeinanderlegen.

## Patentansprüche

1. Stapelvorrichtung für einheitliche, insbesondere plattenförmige Teile, mit einer Fördereinrichtung und einem Behälter, in welchem die von der Fördereinrichtung herangeführten Teile Frontseite gegen Rückseite abgelegt werden, dadurch gekennzeichnet, daß die abgelegten Teile (5) durch separat zugeführte Zwischenlagen (30) voneinander getrennt sind, welche als in sich formsteife Rahmen ausgebildet sind, die an Randbereichen der Front- und der Rückseiten der abgelegten Teile (5) anliegen.

2. Stapelvorrichtung nach Anspruch 1, dadurch gekennzeichnet, daß die Zwischenlagen (30) in einem Magazin angeordnet sind, und daß in dem Magazin eine Vorrichtung zum Transport bzw. zur Freigabe jeweils einer Zwischenlage zwischen zwei aufeinanderfolgenden Teileablagen vorgesehen ist.

3. Stapelvorrichtung nach Anspruch 2, dadurch gekennzeichnet, daß das Magazin und die Vorrichtung zum Transport bzw. zur Freigabe der Zwischenlagen (30) innerhalb des zur Ablage der Teile (5) dienenden Behälters (16) angeordnet sind.

4. Stapelvorrichtung nach Anspruch 3, dadurch gekennzeichnet, daß der die abgelegten Teile (5) aufnehmende Behälter (16) als Magazin für die Zwischenlagen (30) ausgebildet ist.

5. Stapelvorrichtung nach Anspruch 4, dadurch gekennzeichnet, daß der Behälter (16) zur Fördereinrichtung (8) hin offen und während des Stapelvorgangs entgegen der Stapelrichtung beweglich ist, und daß die Zwischenlagen (30) unter Belassung eines Freiraums (38) zum Ablegen jeweils eines Teils (5) im Behälter gelagert sind.

6. Stapelvorrichtung nach Anspruch 7, dadurch gekennzeichnet, daß die Zwischenlagen (30) an zwei parallelen Wänden (17, 18) nahe ihrer rückwärtigen Begrenzungskante schwenkbar gelagert sind und sich mit ihrer gegenüberliegenden, der Fördereinrichtung (8) zugekehrten Kante unter Schrägstellung der Zwischenlagen an gerätefest angeordneten Leisten (36, 37) abstützen, die sich in Bewegungsrichtung des Behälters (16) erstrecken.

7. Stapelvorrichtung nach Anspruch 5 oder 6, dadurch gekennzeichnet, daß dem Behälter (16) ein vorzugsweise als Winkelstück (21) ausgebildeter Träger zugeordnet ist, welcher in Bewegungsrichtung des Behälters kontinuierlich verschiebbar geführt ist.

8. Stapelvorrichtung nach Anspruch 7, dadurch gekennzeichnet, daß zum kontinuierlichen Verschieben des Behälters (16) ein Getriebe dient, dessen Vorschubrate auf diejenige der Fördereinrichtung (8) abgestimmt ist.

9. Stapelvorrichtung nach Anspruch 8, dadurch gekennzeichnet, daß das Getriebe eine gerätefest gelagerte Gewindespindel (25) enthält, welche eine am Träger (16) befestigte Mutter (24) durchgreift, die aus zwei zu öffnenden Gewindehalbschalen besteht.

10. Stapelvorrichtung nach Anspruch 9, dadurch gekennzeichnet, daß zwischen der Gewindespindel (25) und einem diese antreibenden Motor eine lösbare Kupplung (29) angeordnet ist.

## Claims

1. Piling device for uniform objects, particularly plate-like objects, having a conveyor device and a container in which the objects brought up by the conveyor device are deposited front side against rear side, characterized in that the deposited objects (5) are separated from each other by separately fed separators (30) which are constructed as inherently rigid frames which contact the edge regions of the front and rear sides of the deposited objects (5).

2. Piling device according to Claim 1, characterized in that the separators (30) are arranged in a magazine, and that a device to transport or release a separator between each two consecutive objects deposited is provided in the magazine.

3. Piling device according to Claim 2, characterized in that the magazine and the device for the transport or for the release of the separators (30) are arranged within the container (16) which serves for depositing the objects (5).

4. Piling device according to Claim 3, characterized in that the container (16) which houses the deposited objects (5) is constructed as a magazine for the separators (30).

5. Piling device according to Claim 4, characterized in that the container (16) is open towards the conveyor device (8) and movable counter to the piling direction during the piling process, and that the separators (30) are stored in the container leaving a clearance (38) for depositing an object (5) in each case.

6. Piling device according to Claim 5, characterized in that the separators (30) are supported pivotably near their rear boundary edge on two parallel walls (17, 18) and are braced by their opposite edge facing the conveyor device (8), the separators being positioned obliquely, on bars (36, 37) arranged fixed to the appliance which extend in the direction of movement of the container (16).

7. Piling device according to Claim 5 or 6, characterized in that a bracket preferably constructed as an angle piece (21), which is guided continuously slidably in the direction of movement of the container, is associated with the container (16).

8. Piling device according to Claim 7, characterized in that a transmission means, the feed speed of which is co-ordinated with that of the conveyor device (8), serves for the continuous sliding of the container (16).

9. Piling device according to Claim 8, characterized in that the transmission means comprises a screwthreaded spindle (25) mounted fixed on the appliance, which penetrates a nut (24) fastened to the bracket (16) (sic) which comprises two openable screwthreaded half-shells.

10. Piling device according to Claim 9, characterized in that a releasable coupling (29) is arranged between the screwthreaded spindle (25) and a motor which drives the latter.

## Revendications

1. Dispositif d'empilage d'objets uniformes, notamment en forme de plaques, avec un dispositif de transport et un récipient, dans lequel les objets amenés par le dispositif de transport sont déposés côté avant contre côté arrière, caractérisé en ce que les objets déposés (5) sont séparés les une des autres par des couches intermédiaires (30) alimentées séparément, qui sont réalisées sous forme de cadre de forme rigide, appuyant sur les zones de bordure des côtés avant et arrière des objets déposés (5).

2. Dispositif d'empilage selon la revendication 1, caractérisé en ce que les couches intermédiaires (30) sont disposées dans un magasin, et en ce qu'il est prévu dans le magasin un dispositif de transport ou de libération de chaque fois une couche intermédiaire entre deux dépôts d'objet successifs.

3. Dispositif d'empilage selon la revendication 2, caractérisé en ce que le magasin et le dispositif de transport ou de libération des couches intermédiaires (30) sont disposés à l'intérieur du récipient (16) servant à déposer les objets (5).

4. Dispositif d'empilage selon la revendication 3, caractérisé en ce que le récipient (16) recevant les objets (5) déposés est réalisé sous forme de magasin pour les couches intermédiaires (30).

5. Dispositif d'empilage selon la revendication 4, caractérisé en ce que le récipient (16) est ouvert vers le dispositif de transport (8) et mobile pendant le processus d'empilage, à l'opposé du sens d'empilage, et en ce que les couches intermédiaires (30) sont placées dans le récipient en laissant subsister un espace libre (38) pour déposer chaque fois un objet (5).

6. Dispositif d'empilage selon la revendication 5, caractérisé en ce que les couches intermédiaires (30) sont placées pivotantes sur deux parois (17, 18) parallèles, à proximité de leur arête de délimitation arrière, et s'appuient avec leur arête opposée, tournée vers le dispositif de transport (8), en position inclinée des couches intermédiaires sur des bandes (36, 37) disposées fixes par rapport à l'appareil et s'étendant dans le sens du déplacement du récipient (16).

7. Dispositif d'empilage selon la revendication 5 ou 6, caractérisé en ce qu'un support réalisé de préférence sous forme de pièce de cornière (21) est affecté au récipient (16), support guidé de manière mobile continue dans le sens de déplacement du récipient.

8. Dispositif d'empilage selon la revendication 7, caractérisé en ce qu'une transmission dont le taux d'avance est déterminé en fonction de celui du dispositif de transport (8) sert à produire un déplacement continu du récipient (16).

9. Dispositif d'empilage selon la revendication 8, caractérisé en ce que la transmission contient une broche filetée (25) montée fixe par rapport à l'appareil et traversant un écrou (24) fixé sur le support (16), écrou se composant de deux demi coquilles filetées ouvrantes.

10. Dispositif d'empilage selon la revendication 9, caractérisé en ce qu'un embrayage (29) est disposé entre la broche filetée (25) et un moteur entraînant celle-ci.

FIG.1

FIG.2

FIG.3

FIG.4